# EUROPEAN PATENT SPECIFICATION

(11) **EP 2 721 633 B1**
(45) Date of publication and mention of the grant of the patent: **05.05.2021**
(21) Application number: 12801910.6
(22) Date of filing: 20.06.2012
(51) Int. Cl.: H01L 21/00, H01L 33/00, C09K 11/02, B82Y 10/00, B82Y 30/00, H01L 29/06, C09K 11/56, C09K 11/88, C09K 11/74, C09K 11/89

(54) **STABILIZED NANOCRYSTALS**
STABILISIERTE NANOKRISTALLE
NANO-CRISTAUX STABILISÉS

(30) Priority: 20.06.2011 US 201161498983 P
(43) Date of publication of application: 23.04.2014
(73) Proprietor: Crystalplex Corporation, Pittsburgh, Pennsylvania 15203 (US)
(72) Inventor: QU, Lianhua, Pittsburgh, Pennsylvania 15237 (US); BOOTMAN, Matthew, W., McMurray, Pennsylvania 15317 (US)
(74) Representative: HGF
(86) International application number: PCT/US2012/043349
(87) International publication number: WO 2012/177761

(56) References cited:
- WO-A1-2011/038111
- US-A- 5 763 085
- US-A1- 2007 087 197
- US-A1- 2010 167 011
- US-A1- 2010 167 011
- US-B2- 7 825 405
- KANEMITSU ET AL: "Excitons in silicon quantum structures", JOURNAL OF LUMINESCENCE, ELSEVIER BV NORTH-HOLLAND, NL, vol. 83-84, 1 November 1999 (1999-11-01), pages 283-290, XP027337601, ISSN: 0022-2313 [retrieved on 1999-11-01]
- VEPREK S: "Electronic and mechanical properties of nanocrystalline composites when approaching molecular size", THIN SOLID FILMS, ELSEVIER-SEQUOIA S.A. LAUSANNE, CH, vol. 297, no. 1-2, 1 April 1997 (1997-04-01), pages 145-153, XP004125985, ISSN: 0040-6090, DOI: 10.1016/S0040-6090(96)09480-1
- SHRABANI PANIGRAHI ET AL: "ZnOSiOcoreshell nanorod composite: Microstructure, emission and photoconductivity properties", CHEMICAL PHYSICS LETTERS, ELSEVIER BV, NL, vol. 511, no. 1, 2 June 2011 (2011-06-02), pages 91-96, XP028236603, ISSN: 0009-2614, DOI: 10.1016/J.CPLETT.2011.06.007 [retrieved on 2011-06-06]

## Description

### CROSS-REFERENCE TO RELATED APPLICATION

This application claims benefit of priority to U.S. Provisional Patent Application No. 61/498,983 entitled STABILIZED NANOCRYSTALS and filed on June 20, 2011.

### BACKGROUND

While researchers in biological fields are looking to quantum dots to replace organic fluorescent dyes, quantum dots also hold promise for use in electronic devices. Research is ongoing into incorporating quantum dots into photovoltaics, solid-state lighting (mainly as quantum dot phosphors), LCD display backlights, electroluminescent displays, and quantum computing devices. Semiconductor light emitting diode (LED) devices have been made since the early 1960s and currently are manufactured for usage in a wide range of consumer and commercial applications. Some of these devices have layers including the LEDs, based on crystalline semiconductor materials that require ultra-high vacuum techniques for their growth, such as, metal organic chemical vapor deposition. In addition, the layers typically need to be grown on nearly lattice-matched substrates in order to form defect- free layers. These crystalline-based inorganic LEDs have the advantages of high brightness (due to layers with high conductivities), long lifetimes, good environmental stability, and good external quantum efficiencies. The usage of crystalline semiconductor layers that results in all of these advantages, also leads to a number of disadvantages including high manufacturing costs, difficulty in combining multi-color output from the same chip, and the need for high cost and rigid substrates.

Since the mid-1980s, LED displays have been brought out into the marketplace and there have been great improvements in device lifetime, efficiency, and brightness. For example, devices containing phosphorescent emitters have external quantum efficiencies as high as 19%; whereas, device lifetimes are routinely reported at many tens of thousands of hours. In comparison to crystalline-based inorganic LEDs, organic LEDs (OLEDs) have much reduced brightness (mainly due to small carrier mobilities), shorter lifetimes, and require expensive encapsulation for device operation. On the other hand, OLEDs enjoy the benefits of potentially lower manufacturing cost, the ability to emit multicolors from the same device, and the promise of flexible displays if the encapsulation issues can be resolved.

To improve the performance of OLEDs, quantum dots were introduced into the emitter layers to enhance the color gamut of the device and reduce manufacturing costs. Because of problems, such as, aggregation of the quantum dots in the emitter layer, the efficiency of these devices was rather low in comparison with typical OLED devices. The efficiency was even poorer when a neat film of quantum dots was used as the emitter layer. Regardless of any future improvements in efficiency, these hybrid devices still suffer from many of the drawbacks associated with pure OLED devices.

Recently, all-inorganic LEDs have been constructed by, for example, sandwiching a monolayer thick core/shell CdSe/ZnS quantum dot layer between vacuum deposited n- and p-GaN layers. However, such devices exhibit poor external quantum efficiency of 0.001 to 0.01% because of organic ligands of trioctylphosphine oxide (TOPO) and trioctylphosphine (TOP) insulators that result in poor electron and hole injection into the quantum dots. In addition, the structure is costly to manufacture, due to electron and whole semiconducting layers grown by high vacuum techniques, and sapphire substrates. Accordingly, it would be highly beneficial to construct an all inorganic LED based on quantum dot emitters which was formed by low cost deposition techniques and whose individual layers showed good conductivity performance. The resulting LED would combine many of the desired attributes of crystalline LEDs with organic LEDs. US Patent Publication No. 2007/0087197 A1 teaches of a nanoparticle coated with SiO₂.

### SUMMARY

In a first aspect of the present invention, there is provided a nanoparticle comprising:
a semiconductor nanocrystal which defines an outermost surface, an inorganic coating substantially covering and directly contacting the outermost surface of the semiconductor nanocrystal, said inorganic coating comprising silicon dioxide and comprising less than 30% organic components, the inorganic coating being formed on the semiconductor nanocrystal by suspending the semiconductor nanocrystal in pyridine and adding silicon dioxide, thereby resulting in pyridine on the surface of the semiconductor nanocrystal being exchanged for silicon dioxide.

In some embodiments, the inorganic coating further comprises silicon monoxide, silicon nitride, zirconium oxide, tantalum oxide, lanthanum oxide, cerium oxide, hafnium oxide, or a combination thereof.

The inorganic coating directly contacts the outermost surface of the semiconductor nanocrystal.

In some embodiments, the inorganic coating forms a passivation layer on the outermost surface of the semiconductor nanocrystal.

In some embodiments, the inorganic coating is substantially free of organic components for example less than about 20% organic components, less than about 10% organic components less than about 5% organic components, less than about 1% organic components.

In some embodiments, the semiconductor nanocrystal comprises a mean particle diameter of from about 1 nm to about 500 nm, from about 1 nm to about 100 nm, or from about 5 nm to about 15 nm.

Some embodiments further comprise at least one secondary inorganic passivation material. In some embodiments, the secondary inorganic passivation material comprises aluminum oxide (Al₂O₃).

Some embodiments provide a powder comprising a plurality of such nanoparticles.

Some embodiments provide an optoelectronic device comprising at least one such nanoparticle.

Some embodiments provide a light emitting device (LED) comprising at least one such nanoparticle.

A method for preparing a nanoparticle comprising providing a suspension of nanocrystals in pyridine; and adding an inorganic coating material to the suspension of nanocrystals in pyridine suspension is described.

The inorganic coating comprises silicon dioxide, silicon monoxide, silicon nitride, zirconium oxide, tantalum oxide, lanthanum oxide, cerium oxide, hafnium oxide, or a combination thereof. The inorganic coating comprises silicon dioxide.

The method further comprises contacting the outermost surface of the semiconductor nanocrystal with the inorganic coating.

The method further comprises forming a passivation layer on the outermost surface of the semiconductor nanocrystal with the inorganic coating.

### DETAILED DESCRIPTION

Embodiments disclosed herein may be understood more readily by reference to the following detailed description and Examples. It is to be understood that the terminology used is for the purpose of describing specific embodiments only and is not intended to be limiting.

Unless defined otherwise, all technical and scientific terms have the same meaning as is commonly understood by one of ordinary skill in the art to which the embodiments disclosed belongs.

As used herein, "a" or "an" means "at least one" or "one or more."

As used herein, "about" means that the numerical value is approximate and small variations would not significantly affect the practice of the disclosed embodiments. Where a numerical limitation is used, unless indicated otherwise by the context, "about" means the numerical value can vary by ±10% and remain within the scope of the disclosed embodiments.

The terms "attached" or "operably bound" as used herein interchangeably to refer to formation of a covalent bond or a non-covalent association between a combination of two or more molecules, of sufficient stability for the purposes of use in detection systems as described herein and standard conditions associated therewith as known in the art. The attachment may comprise, but is not limited to, one or more of a covalent bond, an ionic bond, a hydrogen bond, or a van der Waals interaction.

A "core nanocrystal" is understood to mean a nanocrystal to which no shell has been applied; typically it is a semiconductor nanocrystal. A core nanocrystal can have a homogenous composition or its composition can vary with depth inside the nanocrystal. Many types of nanocrystals are known, and methods for making a core nanocrystal and applying a shell to a core nanocrystal are known in the art. The shell-forming methods described herein are applicable for producing a shell on core nanocrystals. To distinguish a nanocrystal used in disclosed embodiments from one that might be formed unintentionally in a shell-forming step, the nanocrystal introduced into a reaction mixture is referred to as a primary nanocrystal, regardless of whether it is a core nanocrystal or a core/shell nanocrystal. In either event, the methods disclosed herein produce a new shell on the outer surface of the primary nanocrystal.

As used in the claims and specification, the words "comprising" (and any form of comprising, such as "comprise" and "comprises" and "comprised"), "having" (and any form of having, such as "have" and "has"), "including" (and any form of including, such as "includes" and "include"), or "containing" (and any form of containing, such as "contains" and "contain"), are inclusive or open-ended and do not exclude additional, unrecited elements or method steps.

"Monodisperse" as used herein refers to a population of particles (e.g., a colloidal system) wherein the particles have substantially identical size and shape. For the purpose of the present invention, a "monodisperse" population of particles means that at least about 60% of the particles, preferably about 75% to about 90% of the particles, fall within a specified particle size range.

"Optional" or "optionally" may be taken to mean that the subsequently described structure, event or circumstance may or may not occur, and that the description includes instances where the event occurs and instances where it does not.

"Surface layer" as used herein refers to a layer of small-molecule ligands coordinated to the nanocrystal's outer surface, which may be further cross-linked or modified. The surface layer may have other or additional surface coatings that modify the solubility properties of the particle, which are sometimes referred to herein as "coating layers," "capping layers," or "coatings."

"Semiconductor" as used herein means any material that exhibits a finite band gap energy in the range of about 0.01 eV to about 10 eV.

"Nanocrystal" as used herein can refer to a particle made out of an inorganic substance that typically has an ordered crystalline structure having at least one major dimension in the nanosize range, for example, at least one major dimension measuring from 1 to 1000 nanometers. The term "nanocrystal" can refer to a "core nanocrystal" consisting of crystalline particle, or a "core/shell nanocrystal," which describes a nanocrystal having a nanocrystal core of a first material and a shell layer of a second material surrounding the core. In general, a nanocrystal including both core and core/shell nanocrystal can have a diameter of from about 1 to about 1000 nm, about 1 nm to about 100 nm, or about 1 nm to 50 nm.

The nanocrystals, such as those used in the embodiments described herein, can be bright fluorescent nanocrystals and quantum dots prepared from such bright fluorescent nanocrystals can also be bright. For example, a typical quantum yield for a nanocrystal can be at least about 10%, at least 20%, at least 30%, at least 40%, and at least 50% or greater than 50%. In some embodiments, nanocrystals can have a surface layer of ligands to protect them from degradation during use or while in storage; thus isolated nanocrystals made by the methods of embodiments can have a surface layer of ligands on the outside of the shell of the nanocrystal.

"Nanoparticle" as used herein refers to any nanocrystal, such as a core nanocrystal or core/shell nanocrystal, having any associated organic or inorganic coating or other material on the surface of the nanocrystal that is not removed from the surface by ordinary solvation. The organic coating or other material can further be cross-linked, can have other or additional surface coatings that can modify the properties of the particle, for example, increasing or decreasing solubility in water or other solvents. Nanocrystals having such crosslinked or modified coatings on their surfaces are encompassed by the term 'nanoparticle.'

"Quantum dot" as used herein typically refers to a nanocrystalline particle made from a material that in the bulk is a semiconductor or insulating material, which has a tunable photophysical property in the near ultraviolet (UV) to far infrared (IR) range, and in particular, the visible range.

Various embodiments of the invention are directed to nanocrystals and quantum dots having an inorganic coating, methods for preparing such nanocrystals and quantum dots, and methods for using these nanocrystals and quantum dots. In such embodiments, the nanocrystals and quantum dots may include a semiconductor nanocrystal defining an outermost surface and an inorganic coating covering the outermost surface of the nanocrystal.

Nanocrystals and quantum dots heretofore described must include organic components, such as organic ligands that bind to an outermost surface of the nanocrystal. These organic ligands passivate the nanocrystal and provide an environment in which the nanocrystal can fluoresce. Removing the organic layer renders the nanocrystal or quantum dot unable to fluoresce, and therefore, unsatisfactory for its intended purpose.

The nanocrystals and quantum dots described herein do not include organic ligands normally associated with semiconductor nanoparticles. For example, in various embodiments, the inorganic coating may include less than about 30% organic components, less than 20%, less than 10%, less than 5%, or less than 1% organic components, and in certain embodiments, the inorganic coating may include substantially no organic components, which may encompass 0% or very near 0% organic components. The inorganic coating of such embodiments may bind directly to the outermost surface of the nanocrystal, and in particular embodiments, the inorganic coating may provide a passivation layer or the outermost surface of the nanocrystal. For clarity, in some embodiments, the semiconductor nanoparticle does not include any organic ligand, but rather includes an inorganic coating in its place.

While not wishing to be bound by theory, the nanocrystals and quantum dots described herein may provide sufficient fluorescence for any purpose currently practiced using the organic ligand coated nanoparticles of the prior art including, but not limited to, biological applications as, for example, signaling molecules. In addition, the nanocrystals and quantum dots described herein exhibit significantly improved fluorescence and improved fluorescence half-life when compared to quantum dots having an organic coating.

For example, in some embodiments, the fluorescence half-life of the nanocrystals and quantum dots described herein may be greater than 15,000 hours, greater than 20,000 hours, greater than 25,000 hours, greater than 30,000 hours, greater than 35,000 hours, or greater than 40,000 hours without significant loss of fluorescence. Therefore, the nanocrystals and quantum dots of the invention may have a useful life of at least 30,000 hours to greater than 100,000 hours making these nanocrystals particularly well-suited for applications in which the particle longevity is important, such as, for example, in fluorescent inks and dyes, optoelectronic devices, and light emitting devices (LEDs), such as, for example, displays and solid state lighting. Thus, certain embodiments of the invention are directed to a fluorescent ink or dye or a display including at least one nanocrystal or quantum dot having an inorganic coating covering the outermost surface of the nanocrystal in which presence of organic components is significantly reduced or organic components are eliminated.

The semiconductor nanocrystals and quantum dots of embodiments can be made of any suitable metal and non-metal atoms that are known to form semiconductor nanocrystals. For example, the semiconductor nanocrystals of various embodiments can be prepared from materials including, but are not limited to, Group 2-16, 12-16, 13-15 and 14 elements, and combining appropriate precursors can result in semiconductor nanocrystals such as, but not limited to, ZnS, ZnSe, ZnTe, CdS, CdSe, CdTe, HgS, HgSe, HgTe, MgS, MgSe, MgTe, CaS, CaSe, CaTe, SrS, SrSe, SrTe, BaS, BaSe, BaTe, GaN, GaP, GaAs, GaSb, InP, InAs, InSb, AlAs, AlP, AlSb, PbS, PbSe, Ge and Si and binary, ternary and quaternary mixtures thereof, and the like.

In particular embodiments, the nanocrystals or quantum dots may be alloyed 2-6-6 SCNs having, for example, the formula WYₓZ_{(1-X)}, where W is a Group II element, Y and Z are different Group VI elements, and 0<X<1. The term "2-6-6 SCN" represents a 3- element alloyed semiconductor with a Group II element-Group VI element-Group VI element composition. In some embodiments, the nanocrystals and quantum dots described herein may include Cd, Se and S. Alloyed semiconductor nanocrystals are known in the art, for example, as described in WIPO Publication No. WO 2005/001889 and U.S. Publication No. 2006/0028882. The term "alloyed" refers to two or more semiconductor materials forming a completely amalgamated solid wherein the two or more semiconductor materials are randomly distributed throughout the solid. In this respect, the term "alloy" refers to any solid, which is a product of an amalgamation process.

In particular embodiments, the semiconductor materials of alloyed nanocrystals and quantum dots may have a gradient of one or more of the semiconductor materials radiating from the center of the nanocrystal or quantum dot to the outermost surface of the nanocrystal. Such nanocrystals or quantum dots are referred to herein as "concentration-gradient quantum dots." For example, in some embodiments, a concentration-gradient quantum dot having at least a first semiconductor and a second semiconductor may be prepared such that the concentration of the first semiconductor gradually increases from the center of the concentration-gradient quantum dot to the surface of the quantum dot. In such embodiments, the concentration of the second semiconductor can gradually decrease from the core of the concentration-gradient quantum dot to the surface of the quantum dot. Without wishing to be bound by theory, concentration-gradient quantum dot may have a band gap energy that is non-linearly related to the molar ratio of the at least two semiconductors.

Concentration-gradient quantum dots may be prepared from any semiconductor material known in the art including those semiconductor materials listed above, and concentration-gradient quantum dots may be composed of two or more semiconductor materials. In particular embodiments, concentration-gradient quantum dots may be alloys of CdSeTe having a molecular formula CdS₁₋ₓTeₓ CdSSe having a molecular formula CdS₁₋ₓSeₓ, CdSTe having a molecular formula CdS₁₋ₓTeₓ, ZnSeTe having a molecular formula ZnSe₁₋ₓTeₓ, ZnCdTe having a molecular formula Zn₁₋ₓCdxTe, CdHgS having a molecular formula Cd₁₋ₓHgxS, HgCdTe having a molecular formula HgCdTe, InGaAs having a molecular formula InGaS, GaAlAs having a molecular formula GaAlAs, or InGaN having a molecular formula InGaN, where x in each example can be any fraction between 0 and 1.

In some embodiments, a core nanocrystal can be modified to enhance the efficiency and stability of its fluorescence emissions by coating a nanocrystal core with a semiconductor material to create a shell around the nanocrystal core thereby creating a core/shell nanocrystal, and in some embodiments, the nanocrystals may include more than one shell. The core/shell nanocrystals of such embodiments can have two or more distinct layers: a semiconductor or metallic core and one or more shells of an insulating or semiconductor material surrounding the core.

By "semiconductor shell" is meant a thin layer of semiconductor material (typically 1-10 atomic layers thick) deposited on the outer surface of a core nanocrystal. This "semiconductor shell" can be composed of the same material as the core or a different the semiconductor material than the core, and in some embodiments, at least one semiconductor material in the shell may be different than the semiconductor materials making up the core. The semiconductor shell should have a wider band gap than the core in order to efficiently protect the core electronically and sterically. The semiconductor shell can include any semiconductor material including, but not limited to, Cd, Zn, Ga, Pb, Mg, S, Se, Te, P, As, N, O, Sb, and combinations thereof, and in certain embodiments, the semiconductor shell may include ZnS, CdS, CdSe, CdTe, GaAs, or AlGaAs. The one or more shell layers may be prepared from a uniform dispersion of semiconductor materials or alloyed semiconductor materials having concentration gradients similar to those described for core nanocrystals.

Without wishing to be bound by theory, the addition of a shell may reduce the effect of surface defects on the semiconductor nanocrystal core which can result in traps, or holes, for electrons or other non-radiative energy loss mechanisms that degrade the electrical and optical properties of the core, and either dissipate the energy of an absorbed photon or at least affect the wavelength of the fluorescence emission slightly, resulting in broadening of the emission band. An insulating layer at the surface of the semiconductor nanocrystal core can provide an atomically abrupt jump in the chemical potential at the interface that eliminates energy states that can serve as traps for the electrons and holes resulting in a higher efficiency luminescence. It should be understood that the actual fluorescence wavelength for a particular semiconductor nanocrystal core may depend upon the size of the core as well as its composition. Thus, the emission wavelengths described above are merely approximations, and nanocrystal cores of the various compositions described above may actually emit at longer or shorter wavelengths depending upon their size.

The nanocrystals, quantum dots, and concentration-gradient nanocrystals of various embodiments can be of any size. For example, nanocrystals useful in embodiments may have a mean particle diameter (MPD) of form about 1 nm to about 100 nm, from about 1 to about 50 nm, and from about 1 to about 25 nm. More specific nanocrystals and quantum dots useful in embodiments can include, but are not limited to, those nanocrystals having an MPD of from about 0.5 nm to about 5 nm, about 1 nm to about 50 nm, about 2nm to about 50 nm, about 1 nm to about 20 nm, about 2 nm to about 20 nm, or from about 2 to about 10 nm. For example, in particular embodiments, nanocrystals may have an MPD of, about 0.5 nm, about 1 nm, about 2 nm, about 3 nm, about 4 nm, about 5 nm, about 6 nm, about 7 nm, about 8 nm, about 9 nm, about 10 nm, about 11 nm, about 12 nm, about 13 nm, about 14 nm, about 15 nm, about 16 nm, about 17 nm, about 18 nm, about 19 nm, about 20 nm, about 25 nm, about 30 nm, about 35 nm, about 40 nm, about 45 nm, about 50 nm, and the like and an MPD between any two values listed above. For a nanocrystal that is not substantially spherical, e.g., rod-shaped, the diameter at its smallest dimension may be from about 1 to about 100 nm, or from about 1 nm to about 50 nm or 1 nm to about 25 nm.

A typical single-color preparation of nanocrystals or quantum dots includes crystals that are preferably of substantially identical size and shape, and in some embodiments, the nanocrystals or quantum dots of embodiments can be roughly spherical. In other embodiments, the nanocrystals can be of any of numerous non-spherical shapes. For example, nanocrystals can be synthesized in a variety of shapes including, but not limited to, spheres, rods, discs, pyramid or pyramid like, nanorings, nanoshells, tetrapods, nanowires, and so on. Without wishing to be bound by theory, nanocrystals of different morphologies can have distinctive properties such as spatial distribution of the surface charge, orientation dependence of polarization of the incident light wave, and spatial extent of the electric field, and these distinctive properties may provide nanocrystals that are useful for particular purposes. In certain embodiments, the non-spherical nanocrystals may be useful based on their emission color.

It is well known that the color (emitted light) of the semiconductor nanocrystal can be "tuned" by varying the size and composition of the nanocrystal. Nanocrystals can absorb a wide spectrum of wavelengths, and emit a narrow wavelength of light. The excitation and emission wavelengths are typically different, and non-overlapping. The nanocrystals of a monodisperse population may be characterized in that they produce a fluorescence emission having a relatively narrow wavelength band. Examples of emission widths (full-width at half-maximum of the emission band, FWHM) useful in embodiments include less than about 200 nm, less than about 175 nm, less than about 150 nm, less than about 125 nm, less than about 100 nm, less than about 75 nm, less than about 60 nm, less than about 50 nm, less than about 40 nm, less than about 30 nm, less than about 20 nm, and less than about 10 nm. In particular embodiments, the FWHM can from about 20 nm to about 50 nm or from about 30 nm to about 35 nm.

The relationship between size and fluorescence wavelength of nanocrystals is well known, and in general, the nanocrystals of embodiments can be sized to provide fluorescence in the UV, visible, or infrared portions of the electromagnetic spectrum because this range is convenient for use in monitoring biological and biochemical events in relevant media. For example, in some embodiments, a CdSe nanocrystal having a diameter of about 3 nm may emit at a wavelength of about 525 nm, and in other embodiments, a ZnTe nanocrystal having a diameter of about 6 nm to about 8 nm may emit at a wavelength of about 525 nm. In still other embodiments, InP or InAs nanocrystals having a smaller diameter may emit at the same wavelength. In such embodiments, a ZnTe nanocrystal having generally larger diameters may have a larger absorption cross-section and produce brighter fluorescence. In other embodiments, a smaller nanocrystal may be necessary to, for example, achieve an appropriate hydrodynamic radius and maximize renal clearance for in vivo use, and the CdSe, InP, or InAs nanocrystals may be preferred.

Preparations of concentration-gradient quantum dots of various embodiments may similarly have substantially identical size and shape. However, unlike conventional quantum dots that are not alloyed and do not have a concentration gradient of semiconductor materials, varying the concentration of semiconductor materials and/or the extent of the concentration gradient can result in different populations of quantum dots of substantially the same size that fluoresce at different wavelengths thereby providing populations of quantum dots having substantially the same MPD that fluoresce at different colors. Thus, certain embodiments of the invention are directed to a population of concentration-gradient quantum dots having substantially the same diameter and exhibiting different colors when excited. Such concentration-gradient nanocrystals may be particularly well suited for use in optoelectric devices and LEDs.

In various embodiments, a significant proportion of the nanocrystals used in a particular application may be the same substantially size. For example, in some embodiments, at least about 60%, at least about 70%, at least about 80%, at least about 90%, at least about 95%, or about 100% of the nanocrystals can be substantially the same size. One of ordinary skill in the art will realize that particular sizes of nanocrystals, such as of semiconductor nanocrystals, are generally obtained as particle size distributions. The variance in diameter or size dispersity of populations of nanocrystal can be described as the root mean square ("rms"), where the smallest major axis may generally be used as the diameter for non-spherical particles. The root mean square of the nanocrystal populations used in embodiments can be less than about 30% rms, less than about 20% rms, or less than about 10% rms and in certain embodiments, less than about 9% rms, less than about 8% rms, less than about 7% rms, less than about 6% rms, less than about 5% rms, or a percentage between any two values listed. Such a collection of particles may sometimes be referred to as being "monodisperse."

The quantum yield for the nanocrystals of various embodiments can be greater than about 10%, greater than about 20%, greater than about 30%, greater than about 40%, greater than about 50%, greater than about 60%, greater than about 70%, greater than about 80%, greater than about 90%, and ranges between any two of these values, and in particular embodiments, the quantum yield can be greater than about 30%, greater than about 50% or greater than about 70%. In some embodiments, a core nanocrystal can be less than about 10 nm in diameter, or less than about 7 nm in diameter, or less than about 5 nm in diameter.

In some embodiments, the emitted light can have a symmetrical emission of wavelengths. The emission maxima can be at any wavelength from about 200 nm to about 2,000 nm. Examples of emission maxima useful in embodiments can include, but are not limited to, about 200 nm, about 400 nm, about 600 nm, about 800 nm, about 1,000 nm, about 1,200 nm, about 1,400 nm, about 1,600 nm, about 1,800 nm, about 2,000 nm, and ranges between any two of these values. The fluorescence of a monodisperse population of nanocrystals can be characterized by the wavelength of light emitted when irradiated, and the emission maximum for a particular species can be selected by the skilled artisan to provide nanocrystals of any color. In various embodiments, the spectral range of a monodisperse population of nanocrystals encompassed by embodiments can be from about 370 nm to about 1200 nm, about 370 nm to about 900 nm, or from about 470 nm to about 800 nm, and in certain embodiments, nanocrystals, about 460 nm, about 525 nm, about 565 nm, about 585 nm, about 605 nm, about 625 nm, about 655 nm, about 705 nm, or about 800 nm.

An inorganic coating can be applied to any of these semiconducting nanocrystals or quantum dots may form the core to which an to achieve the stabilized nanocrystals described herein. SiO₂ is used either alone or in combination with any inorganic material to provide the inorganic coating of the nanocrystals and quantum dots of various embodiments. For example, in some embodiments, the inorganic coating may further include silicon monoxide, silicon nitride, zirconium oxide, tantalum oxide, lanthanum oxide, cerium oxide, hafnium oxide, or a combination thereof. As discussed above, in embodiments, the inorganic coating may include substantially no organic components. However, in some embodiments, the inorganic coating may include less than about 30% organic components, less than 20%, less than 10%, less than 5%, or less than 1% organic components. The organic components may represent residual ligand used during synthesis of the nanocrystal or quantum dot. In some embodiments, organic components may be used to tailor the activity of the nanocrystal or quantum and may be intentionally included in the coating composition.

As discussed above, a passivation layer may formed on the outermost surface of the nanocrystal to provide a non-reactive layer on the surface of the nanocrystal to provide a tighter confinement of the quantum-mechanical wave functions so they do not extend beyond the surface of the passivation material. Thus, the quantum-mechanical bandgap of the passivation material should be of sufficient magnitude to prevent undesired interaction of the nanocrystal's desired wave functions with the ambient chemical environment. In addition, passivation may prevent chemical contamination of the nanocrystal further enhancing the stability of the passivation material.

In some embodiments, passivation may be enhanced by providing a secondary inorganic passivation material in addition to the inorganic coating material. Any passivation material known in the art may be used in this regard, and in certain embodiments, one or more secondary passivation materials may be present in one or more layers. Exemplary secondary passivation materials include, but are not limited to, aluminum, carbon, silicon, and combinations thereof. In certain embodiments, the secondary passivation material may be aluminum. Aluminum is a well-known oxygen scavenger and forms aluminum oxide (Al₂0₃), which provides a strong barrier to oxidation and other degradation processes. Al₂0₃ is also optically transparent and has a band gap for electrons and holes much greater than many of the semiconducting materials in the quantum dots themselves.

Particular embodiments are directed to a nanocrystal or quantum dot having a concentration gradient 2-6-6 core, a first shell of a binary semiconductor material, a second shell of a binary semiconductor material, a tertiary semiconductor material, or combination thereof, and a passivation layer including inorganic materials. For example, in some embodiments, the core may be a concentration-gradient CdSeS nanocrystal in which the gradient may be varied to produce nanocrystals the fluoresce in different colors, a first shell layer of CdS or ZnS, and a second shell layer of ZnS, ZnCdS, or a combination of ZnS and ZnCdS. The passivation layer includes SiO₂, such as fumed silica (SiO₂), or a combination of AI₂O₃ and SiO₂. In some embodiments, the first and second shell layers may be uniform, and in other embodiments, the first and second shell layers may be alloyed to produce concentration-gradient shell layers.

Further contemplated are methods for preparing the nanocrystals and quantum dots having an inorganic coating. Such embodiments, generally, include the steps of forming a nanocrystal or quantum dot having an organic coating and replacing the organic coating with an inorganic coating material. The step of replacing may include the individual steps of removing or stripping the organic coating material from the outer surface of the nanocrystal or quantum dot, providing an inorganic coating material capable of binding to the outer surface of the nanocrystal, and binding the inorganic coating material to the outer surface of the nanocrystal or quantum dot. Methods for preparing nanocrystals and quantum dots having an inorganic coating may include the step of purifying the coated nanocrystal. The step of purifying may be carried out by any method. For example, in some embodiments, the nanocrystals can be purified by submersing the nanocrystals in a solvent solution and removing the nanocrystals from the solution. Any solvent may be used to purify the nanocrystals, and in certain embodiments, the solvent solution may be a one or more organic solvents.

Typically, quantum dots are synthesized and purified in coordinating organic molecules that are, generally, soap-like with a polar head and a non-polar tail region. The polar head binds to metal atoms on the surface of the quantum dots via electrostatic forces and the non-polar region provides solubility in solvents. This is adequate if quantum dots are to be used in solution. In some applications, it may be desirable to isolate quantum dots in dry form without solvents and without organic ligands or other components attached.

The solvent may act simultaneously as a solvent and a weak-binding ligand for quantum dots. For example, one solvent that meets these criteria is pyridine. Thus, embodiments, are directed to methods for preparing quantum dots using pyridine as the solvent. In addition to weakly-binding the quantum dots and providing a solvent for exchange of passivating ligands, pyridine forms an interpenetrating gel network with many inorganic compounds that may be used to form the inorganic coating such as, for example, fumed silica thereby stabilizing these coating materials.

Quantum dots may be prepared and isolated in the customary manner and, therefore, may include a coating of organic ligands. The organic ligands may be dissociated from the quantum dot and replaced with pyridine by, for example, combining the ligand coated nanoparticles with a sufficient amount of pyridine and heating this mixture. Pyridine may be the primary solvent in each step of the synthesis process. By such methods, quantum dots can be isolated in pure form in pyridine and/or suspended in pyridine to create a suspension of nanocrystals in pyridine.

After the quantum dots have been isolated and/or suspended in pure pyridine, the inorganic coating material may be added to the quantum dot/pyridine suspension at a weight ratio sufficient to coat the quantum dot with inorganic coating material. The inorganic coating may be fumed silica. Fumed silica consists of molecule-sized particles of amorphous silica (SiO₂) fused into branched, chainlike, three-dimensional secondary particles. These particles have a high density of oxygen atoms with available electrons for electrostatic binding to the surface of the quantum dots. The high density of oxygen atoms allows the fumed silica to dislodge the pyridine from the surface of the quantum dot allowing the fumed silica to bind directly to the outermost surface of the quantum dot, substantially without an intervening organic ligand.

Following exchange of the pyridine for fumed silica on the outermost surface of the nanocrystals, the pyridine can then be evaporated from the suspension leaving a dry powder of quantum dots complexed with fumed silica. Thus, embodiments of the invention include a dry powder of quantum dots complexed with fumed silica. The quantum dot/fumed silica complex includes less than about 30% organic components, less than 20%, less than 10%, less than 5%, or less than 1% organic components, and in particular embodiments, the quantum dot/fumed silica complex may include an inorganic coating having substantially no organic components. Moreover, the quantum dot/fumed silica complex is stable and exhibits persistent fluorescence outside of solution and in the absence of organic ligands and organic solvents.

The precursors used in the preparation of the nanocrystals and quantum dots of various embodiments may be prepared from any known precursors. In particular, suitable core and shell precursors useful for preparing semiconductor cores are known in the art and can include group II elements, group XII elements, group XIII elements, group XIV elements, group XV elements, group XVI elements, and salt forms thereof. For example, a first precursor may include metal salt (M⁺X⁻) including a metal atom (M⁺) such as, for example, Zn, Cd, Hg, Mg, Ca, Sr, Ba, Ga, Al, Pb, Ge, Si, or in salts and a counter ion (X⁻), or organometallic species such as, for example, dialkyl metal complexes. In such embodiments, first precursors can include zinc salts, such as zinc carboxylate salts, including zinc acetate, zinc oleate, and zinc stearate, and the like, as well as zinc chloride, and organometallic precursors, such as diethyl zinc, and mixtures thereof. In other embodiments, suitable a first precursor can include zinc phosphonates, zinc phosphinic acids, cadmium phosphonates, cadmium phosphinic acids, and mixtures thereof. In still other embodiments, a first precursor can include cadmium salts, such as cadmium carboxylate salts, including cadmium acetate, cadmium oleate, and cadmium stearate, and the like, as well as cadmium nitrate, cadmium oxide, and organometallic precursors, such as dimethyl cadmium, and mixtures thereof.

A second precursor may include a non-metal atom, which may be provided as an ionic or neutral non-metal species. In some embodiments, a second precursor may include one or more of elemental sulfur, elemental phosphorous, elemental selenium, or elemental tellurium precursors, or in other embodiments, a second precursor may include one or more complexes of, for example, sulfur, selenium, or tellurium with chalcogen sources such as TOP to produce TOPS, TOPSe or TOPTe, or bis(trimethylsilyl) to produce TMS₂S, TMS₂Se, TMS₃P, TMS₃AS, or TMS₂Te. In still other embodiments, second precursors can include, but are not limited to, oleylamine sulfide, oleylamine selenide, oleylamine telluride, decylamine sulfide, decylamine selenide, decylamine telluride, octadecene sulfide, octadecene selenide, octadecene telluride, and mixtures thereof. The selection of suitable precursors for the preparation of various core and core/shell nanocrystals is within the purview of those of ordinary skill in the art.

Formation of the shell may be carried out by any method. For example, in some embodiments, a core/shell nanocrystal may be prepared by providing one or more additional semiconductor precursors such as the first core precursor or second core precursors described above, which can be different than the precursors used to form the core, following core preparation, and in certain embodiments, additional solvents, multi-functional ligands, and/or reaction promoters may be provided. In some embodiments, the method may include the step of heating the mixture, and as a result of heating, the additional precursors may precipitate on the surface of the core and provide a shell layer, i.e., a semiconductor or insulator layer over the core. In other embodiments, the additional nanocrystal precursors, solvents, multi-functional ligands, and/or reaction promoters may be added to a heated mixture that contains preformed cores to initiate formation of the shell.

The solvent used in various embodiments may vary. For example, suitable solvents can include, but are not limited to, hydrocarbons, amines, phosphines, carboxylic acids, phosphine oxides, alkylphosphonic acids, and mixtures thereof, and in more specific embodiments, solvents include, octadecene, TOPO, TOP, decylamine, octadecane, dioctylamine, tributylphosphine, oleylamine, oleic acid, and mixtures thereof. In certain embodiments, the core or shell precursor may be in a solution with octadecene, TOPO, or TOP as the solvent.

In various embodiments, the reaction mixture may be heated to a temperature sufficient to form of a core or core/shell nanocrystal, and the step of heating can be carried out for any period of time. For example, in some embodiments, the temperature can be from about 200°C to about 350°C. However, higher or lower temperatures may be appropriate for a particular reaction involving specific precursors and/or multi-functional ligands. The time period may additionally vary based on the precursors and/or multi-functional surface ligands used and in some embodiments, may be from about 30 minutes to about 48 hours. In other embodiments, the time period for heating may be up to about 5 hours, up to about 6 hours, or up to about 12 hours, and in still other embodiments, the time period may be from about 15 minutes to about 4 hours, or from about 30 minutes to about 2 hours. Of course, the time periods of embodiments include any time between the time periods provided above; thus, the time period of various embodiments may be for example, about 45 minutes, or about 1, 1.25, 1.5, 1.75, 2, 2.25, 2.5, 2.75, 3, 3.25, 3.5, 3.75, or 4 hours and so on.

In certain embodiments, the solution or mixture prepared as above can further include, for example, a reaction promoter and additional solvents and/or ligands. For example, a reaction promoter can be added to adjust the oxidation state of one or both of the precursors if the oxidation states of the two precursors would need to be adjusted for reaction to occur. Thus, in some embodiments, nanocrystals prepared according to the methods of this disclosure may have portions of the surface covered by multi-functional ligands described above and other portions of the surface covered by other ligands such as trialkylphosphines, trialkylphosphine oxides, trialkylamines, alkyl carboxylates, and alkyl phosphonic acids.

Other embodiments are directed to optoelectrical devices and LEDs including the nanocrystals and quantum dots of various embodiments described above. For example, embodiments include devices such as, but not limited to display and solid state light sources including at least one nanocrystal or quantum dot described herein having an inorganic coating. The displays in such embodiment are not limited and can be backlight displays, multi-color displays, full color displays, monochrome displays, pixilated displays, and so on, and in some embodiments, the displays may include multiple layers of the quantum dots of the invention. Similarly, the solid state light sources of embodiments, are not limited and can be any type of lighting device.

### EXAMPLES

Various aspects of the present invention will be illustrated with reference to the following non-limiting examples.

### Example 1

1 g of fumed silica is sonicated for 30 min in 50 cc of pyridine to provide a colloidal suspension of fumed silica in pyridine.. To this suspension, is added 2.5 mg of quantum dots in 1 cc of pyridine. The mixture is sonicated for 30 minutes to disperse the quantum dots evenly in the fumed silica/pyridine suspension. The suspension is then dried in a vacuum oven at 85 deg C for one hour leaving a powdered quantum dot/silica composite.

### Example 2

1 g of fumed silica is sonicated for 30 min in 50 cc of 95% ethanol and 5% water to provide a colloidal suspension of fumed silica in ethanol/water. To this suspension, is added 2.5 mg of quantum dots in 1 cc of pyridine. The mixture is sonicated for 30 minutes to disperse the quantum dots evenly in the fumed silica/ethanol-water suspension. The suspension is then dried in a vacuum oven at 85 deg C for one hour leaving a powdered quantum dot/silica composite.

## Claims

1. A nanoparticle comprising:
a semiconductor nanocrystal which defines an outermost surface,
an inorganic coating substantially covering and directly contacting the outermost surface of the semiconductor nanocrystal, said inorganic coating comprising silicon dioxide and comprising less than 30% organic components, the inorganic coating being formed on the semiconductor nanocrystal by suspending the semiconductor nanocrystal in pyridine and adding silicon dioxide, thereby resulting in pyridine on the surface of the semiconductor nanocrystal being exchanged for silicon dioxide.

2. The nanoparticle of claim 1, wherein the inorganic coatings are
substantially free of organic components.

3. The nanoparticle of claim 1, wherein inorganic coatings
comprise less than:-
(a) 20% organic components;
(b) 10% organic components;
(c) 5% organic components, or;
(d) 1% organic components.

4. The nanoparticle of claim 1, wherein the semiconductor nanocrystal comprises a mean particle diameter of from:
(a) 1 nm to about 500 nm;
(b) 1 nm to about 100 nm, or;
(c) 5 nm to about 15 nm.

5. The nanoparticle of claim 1, wherein the semiconductor nanocrystal comprises a core nanocrystal.

6. The nanoparticle of claim 1, wherein the semiconductor nanocrystal comprises an alloy-gradient nanocrystal.

7. The nanoparticle of claim 6, wherein the alloy-gradient nanocrystal:-
(a) is homogenous;
(b) is non-homogeneous, or;
(c) comprises at least one Group II element and two or more different Group VI elements.

8. A powder comprising a plurality of the nanoparticles of claim 1.

9. An optoelectronic device comprising at least one nanoparticle of claim 1.

10. An light emitting device (LED) comprising at least one nanoparticle of claim 1.

## Patentansprüche

1. Nanopartikel, umfassend:
ein Halbleiter-Nanokristall, das eine äußerste Oberfläche definiert;
einen anorganischen Überzug, der die äußerste Oberfläche des Halbleiter-Nanokristalls im Wesentlichen bedeckt und direkt berührt, wobei der anorganische Überzug Siliziumdioxid umfasst und weniger als 30% anorganische Bestandteile umfasst, wobei der anorganische Überzug auf dem Halbleiter-Nanokristall ausgebildet wird durch Auflösen des Halbleiter-Nanokristalls in Pyridin und Zugeben von Siliziumdioxid, was dazu führt, dass Pyridin auf der Oberfläche des Halbleiter-Nanokristalls durch Siliziumdioxid ausgetauscht wird.

2. Nanopartikel nach Anspruch 1, wobei die anorganischen Überzüge im Wesentlichen frei sind von organischen Bestandteilen.

3. Nanopartikel nach Anspruch 1, wobei die anorganischen Überzüge weniger als folgendes umfassen:-
(a) 20% organische Bestandteile;
(b) 10% organische Bestandteile;
(c) 5% organische Bestandteile; oder
(d) 1% organische Bestandteile.

4. Nanopartikel nach Anspruch 1, wobei das Halbleiter-Nanokristall einen der folgenden mittleren Partikeldurchmesser umfasst:
(a) 1 nm bis etwa 500 nm;
(b) 1 nm bis etwa 100 nm; oder
(c) 5 nm bis etwa 15 nm.

5. Nanopartikel nach Anspruch 1, wobei das Halbleiter-Nanokristall ein Kernnanokristall umfasst.

6. Nanopartikel nach Anspruch 1, wobei das Halbleiter-Nanokristall ein Legierungs-Gradienten-Nanokristall umfasst.

7. Nanopartikel nach Anspruch 6, wobei das Legierungs-Gradienten-Nanokristall:
(a) homogen ist;
(b) nicht homogen ist; oder
(c) mindestens ein Element der Gruppe II und zwei oder mehr verschiedene Elemente der Gruppe VI umfasst.

8. Pulver, das eine Mehrzahl von Nanopartikeln nach Anspruch 1 umfasst.

9. Optoelektronische Vorrichtung, die mindestens ein Nanopartikel nach Anspruch 1 umfasst.

10. Lichtemittierende Vorrichtung (LED), die mindestens ein Nanopartikel nach Anspruch 1 umfasst.

## Revendications

1. Nanoparticule comprenant :
un nanocristal semi-conducteur qui définit une surface extérieure,
un revêtement inorganique recouvrant essentiellement et en contact direct avec la surface extérieure du nanocristal semi-conducteur, ledit revêtement inorganique comprenant du dioxyde de silicium et comprenant moins de 30 % de composants organiques, le revêtement inorganique étant formé sur le nanocristal semi-conducteur par suspension du nanocristal semi-conducteur dans de la pyridine et ajout de dioxyde de silicium, ce qui permet de remplacer de la pyridine sur la surface du nanocristal semi-conducteur par du dioxyde de silicium.

2. Nanoparticule de la revendication 1, dans laquelle les revêtements inorganiques sont essentiellement exempts de composants organiques.

3. Nanoparticule de la revendication 1, dans laquelle les revêtements inorganiques comprennent moins de :
(a) 20 % de composants organiques ;
(b) 10 % de composants organiques ;
(c) 5 % de composants organiques ; ou
(d) 1 % de composants organiques.

4. Nanoparticule de la revendication 1, dans laquelle le nanocristal semi-conducteur comprend un diamètre de particule moyen de :
(a) 1 nm à environ 500 nm ;
(b) 1 nm à environ 100 nm ; ou
(c) 5 nm à environ 15 nm.

5. Nanoparticule de la revendication 1, dans laquelle le nanocristal semi-conducteur comprend un nanocristal de noyau.

6. Nanoparticule de la revendication 1, dans laquelle le nanocristal semi-conducteur comprend un nanocristal à gradient d'alliage.

7. Nanoparticule de la revendication 6, dans laquelle le nanocristal à gradient d'alliage :
(a) est homogène ;
(b) est non homogène ; ou
(c) comprend au moins un élément du groupe II et deux ou davantage d'éléments du groupe VI différents.

8. Poudre comprenant une pluralité des nanoparticules de la revendication 1.

9. Dispositif optoélectronique comprenant au moins une nanoparticule de la revendication 1.

10. Dispositif électroluminescent (LED) comprenant au moins une nanoparticule de la revendication 1.
